# EUROPEAN PATENT SPECIFICATION

(11) **EP 3 892 469 B1**
(45) Date of publication and mention of the grant of the patent: **08.11.2023**
(21) Application number: 20169173.0
(22) Date of filing: 10.04.2020
(51) Int. Cl.: B41C 1/10, G03F 7/09

(54) **LITHOGRAPHIC PRINTING PLATE PRECURSOR**
LITHOGRAPHIEDRUCKPLATTENVORLÄUFER
PLAQUE D'IMPRESSION LITHOGRAPHIQUE

(43) Date of publication of application: 13.10.2021
(73) Proprietor: ECO3 BV, 2640 Mortsel (BE)
(72) Inventor: BILLIET, THOMAS, 2640 Mortsel (BE)
(74) Representative: Vanderstede, Els

(56) References cited:
- US-A1- 2010 009 130
- US-A1- 2010 055 607
- US-B2- 7 579 133

## Description

### Technical Field

The invention relates to a novel lithographic printing plate precursor.

### Background Art

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of a radiation sensitive layer on a lithographic support. Imaging and processing renders the so-called lithographic printing plate precursor into a printing plate or master. Image-wise exposure of the radiation sensitive coating to heat or light, typically by means of a digitally modulated exposure device such as a laser, triggers a physical and/or chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate precursors are capable of producing a lithographic image immediately after exposure, the most popular lithographic plate precursors require wet processing since the exposure produces a difference in solubility or difference in rate of dissolution in a developer between the exposed and the non-exposed areas of the coating. In positive working lithographic plate precursors, the exposed areas of the coating dissolve in the developer while the non-exposed areas remain resistant to the developer. In negative-working lithographic plate precursors, the non-exposed areas of the coating dissolve in the developer while the exposed areas remain resistant to the developer. Most lithographic plate precursors contain a hydrophobic coating on a hydrophilic support, so that the areas which remain resistant to the developer define the ink-accepting, hence printing areas of the plate while the hydrophilic support is revealed by the dissolution of the coating in the developer at the non-printing areas.

Photopolymer printing plates rely on a working-mechanism whereby the coating - which typically includes free radical polymerisable compounds - hardens upon exposure. "Hardens" means that the coating becomes insoluble or non-dispersible in the developing solution and may be achieved through polymerization and/or crosslinking of the photosensitive coating upon exposure to light and/or heat. Photopolymer plate precursors can be sensitized to blue, green or red light i.e. wavelengths ranging between 450 and 750 nm, to violet light i.e. wavelengths ranging between 300 and 450 nm or to infrared light i.e. wavelengths ranging between 750 and 1500 nm. Optionally, the exposure step is followed by a heating step to enhance or to speed-up the polymerization and/or crosslinking reaction.

In general, a toplayer or protective overcoat layer over the imageable layer is required to act as an oxygen barrier to provide the desired sensitivity to the plate. A toplayer typically includes water-soluble or water-swellable polymers such as for example polyvinylalcohol and/or copolymers thereof. Besides acting as barrier for oxygen, the toplayer should best be easily removable during processing and be sufficiently transparent for actinic radiation, e.g. from 300 to 450 nm or from 450 to 750 nm or from 750 to 1500 nm.

In order to be able to evaluate the lithographic printing plates for image quality, such as for example image resolution and detail rendering (usually measured with an optical densitometer) before mounting them on the press, the lithographic printing plate precursors often contain a colorant such as a dye or a pigment in the coating. Such colorants provide, after processing, a contrast between the image areas containing the colorant and the hydrophilic support where the coating has been removed which enables the end-user to evaluate the image quality and/or to establish whether or not the precursor has been exposed to light. Furthermore, besides allowing for the evaluation of the image quality, a high contrast between the image and the hydrophilic support is required in order to obtain a good image registration (alignment) of the different printing plates in multi-colour printing in order to ensure image sharpness (resolution) and a correct rendering of the colours in the images present.

However, for photopolymer lithographic printing plates which are processed on-press and thus development of the plate is not carried out *before* mounting the plate on the press, a previous inspection and discrimination of the plate including colorants is not possible. A solution has been provided in the art by including components to the coating which are able to form upon exposure a so-called "print-out image", i.e. an image which is visible before processing. In these materials however, often the photo-initiating system is a reacting component, which induces formation of the print-out image upon exposure, and therefore the lithographic differentiation may be reduced.

Formation of a print-out image for violet sensitized photopolymer systems have been disclosed in for example US 3,359,109; US 3,042,515; US 4,258,123; US 4,139,390; US 5,141,839; US 5,141,842; US 4,232,106; US 4,425,424; US 5,030,548; US 4,598,036; EP 434 968; WO 96/35143 and US 2003/68575.

The formation of a print-out image is also known for heat-sensitive photopolymer lithographic printing plates. Such plates are usually image-wise exposed by an IR laser and often comprise, beside an IR dye as a light-to-heat conversion compound, also a dye which absorbs in the visible light wavelength range and changes colour upon heating. This colour change can be obtained for example with a heat-decomposable dye which bleaches upon heating such as disclosed in EP 897 134, EP 925 916, WO 96/35143, EP 1 300 241. Alternatively, this heat-induced colour change can be the result of a shift of the absorption maximum of a dye absorbing in the visible wavelength range as disclosed in EP 1 502 736 and EP 419 095. A problem associated with these prior art materials where the print-out image is formed by a heat-induced reduction of the visible light absorption or by a switch from a highly colored to a weakly colored coating, is that the obtained print-out images are characterized by only a low contrast between the exposed and the non-exposed areas, high levels of dyes are required, and/or an increased risk of contamination of the processing equipment such as for example the development rinse section.

Contrast-providing colorants obtained from the so-called leuco dyes that switch colour upon changes in pH, temperature, UV light etc, have been widely used in the art. The leuco dye technology involves a switch between two chemical forms whereby one is colourless. If the colour switch is caused by for example pH or temperature, the transformation is reversible. Irreversible switches are typically based on redox reactions.

Thermochromic dye technology as for example disclosed in WO2019/ 219560 involves the design of an IR dye containing a thermocleavable group whereby a colour shift is obtained upon exposure with heat and/or light.

US2010/0009130 discloses a negative-working printing plate comprising an imageable layer and a topcoat layer comprising a water-soluble polymer binder and a composition that is capable of changing color upon exposure to infrared radiation.

US2010/055607 discloses a lithographic printing plate precursor including an image-recording layer containing an infrared absorbing agent, a radical generator and a polymer which exhibits electrical conductivity upon oxidation.

US 77,579,133 discloses a radiation-sensitive medium comprising hydrophilic poly-mer particles including a thermally softenable hydrophobic polymer, a hydrophilic polymer and a bonding compound capable of chemically bonding to the hydrophobic polymer and the hydrophilic polymer.

The classical workflow of photopolymer plates involves first an exposure step of the photopolymer printing plate precursor in a violet or infrared platesetter, followed by an optional pre-heat step, a wash step of the protective overcoat layer, an alkaline developing step, and a rinse and gum step. However, there is a clear evolution in the direction of a simplified workflow where the pre-heat step and/or wash step are eliminated and where the processing and gumming step are carried out in one single step or where processing is carried out with a neutral gum and then gummed in a second step. Alternatively, on-press processing wherein the plate is mounted on the press and the coating layer is developed by interaction with the fountain and/or ink that are supplied to the plate during the press run, has become very popular. During the first rotations of the press, the non-image areas are removed from the support and thereby define the non-printing areas of the plate.

In particular printing plates designed for on-press processing, require lithographic coatings that are sufficiently soluble or dispersible on the press so that a good clean-out (complete removal of the coating at non-printing areas of the image) is obtained. Exposure to high humid environments can often lead to toning (non-image areas accept ink). Moreover, apart from an excellent clean-out behaviour, also the presslife of such printing plates should be optimized. Indeed, both presslife and clean-out performance are determined by the interaction between the coating and the substrate: an optimal presslife requires sufficient adhesion between the substrate and the coating in the image areas, while a good clean-out requires minimal interaction of the coating with the substrate in the non-image areas upon processing. Thus maximizing the clean-out performance may result in reduced image adhesion and consequently in a reduced press life.

Therefore, there is still a need for printing plate precursors which satisfy both presslife and clean-out requirements at the same time.

### Summary of invention

It is an object of the present invention to provide a negative-working printing plate precursor characterized by both a sufficient clean out behaviour and a high presslife.

This object is realized by the printing plate precursor defined in claim 1 with preferred embodiments defined in the dependent claims. The printing plate material of the present invention has the specific feature that it contains a coating comprising at least two layers of which the toplayer includes at least one non-polymeric polyfunctional compound including at least two carboxylic acid and/or carboxylate groups.

According to the current invention, it was surprisingly found that the clean out behaviour - i.e. removal of the non-image areas - is substantially improved by including a non-polymeric polyfunctional compound including at least two carboxylic acid and/or carboxylate groups in the toplayer whereby the occurence of toning on paper prints is highly reduced compared to printing plates without such a non-polymeric polyfunctional acid and/or its salt in the toplayer. This reducing effect is especially observed for printing plate precursors including in the top layer a hydrophobic binder.

Other features, elements, steps, characteristics and advantages of the present invention will become more apparent from the following detailed description of preferred embodiments of the present invention. Specific embodiments of the invention are also defined in the dependent claims.

### Description of embodiments

### The lithographic printing plate precursor

The lithographic printing plate precursor according to the present invention is negative-working, i.e. after exposure and development the non-exposed areas of the coating are removed from the support and define hydrophilic (non-printing) areas, whereas the exposed coating is not removed from the support and defines oleophilic (printing) areas. The hydrophilic areas are defined by the support which has a hydrophilic surface or is provided with a hydrophilic layer. The hydrophobic areas are defined by the coating, hardened upon exposing, optionally followed by a heating step. Areas having hydrophilic properties means areas having a higher affinity for an aqueous solution than for an (oleophilic) ink; areas having hydrophobic properties means areas having a higher affinity for an (oleophilic) ink than for an aqueous solution.

"Hardened" means that the coating becomes insoluble or non-dispersible in the developing solution and may be achieved through polymerization and/or crosslinking of the photosensitive coating, optionally followed by a heating step to enhance or to speed-up the polymerization and/or crosslinking reaction. In this optional heating step, hereinafter also referred to as "pre-heat", the plate precursor is heated, preferably at a temperature of about 80°C to 150°C and preferably during a dwell time of about 5 seconds to 1 minute.

The coating contains a toplayer and at least one layer including a photopolymerisable composition, said layer is also referred to as the "photopolymerisable layer". The toplayer is provided on top of the photopolymerisable layer. The coating may further include other layers such as for example an intermediate layer, located between the support and the photopolymerisable layer and/or between the top layer and the photopolymerisable layer, an adhesion improving layer, a hydrophilizing layer and/or other layers.

The printing plate of the present invention is characterized in that it can be exposed at a low energy density, i.e. below 190 mJ/m²; preferably between 70 and 190 mJ/m²; more preferably between 75 and 150 mJ/m² and most preferably between 80 and 120 mJ/m².

### Toplayer

The coating includes a toplayer or protective overcoat layer which may act as an oxygen barrier layer. Low molecular weight substances present in the air may deteriorate or even inhibit image formation and therefore a toplayer is applied to the coating. A toplayer should preferably be easily removable during development, adhere sufficiently to the photopolymerisable layer or optional other layers of the coating and should preferably not inhibit the transmission of light during exposure. The toplayer is provided on top of the photopolymerisable layer.

The toplayer includes at least one non-polymeric polyfunctional acid and/or its salt, further also referred to as "polyfunctional compound". The polyfunctional compound is non-polymeric and comprises at least two, more preferably at least three and most preferably three carboxylic acid and/or carboxylate groups. The polyfunctional compound is preferably an aliphatic or aromatic organic polyfunctional compound. In the context of this invention non-polymeric means that the compound does not include more than two repeating units.

Suitable aliphatic organic polyfunctional compounds include tartaric acid, succinic acid, malonic acid, oxalic acid, glutaric acid, aconitric acid, carballylic acid, citric acid and isocitric acid, and/or a salt thereof.

Suitable aromatic organic polyfunctional compounds include phthalic acid, isophtalic acid, terephtalic acid and trimelitic acid, and/or a salt thereof.

The polyfunctional compound is preferably an aliphatic organic polyfunctional compound. Most preferably, the polyfunctional compound is selected from citric acid or isocitric acid, and/or their salts - i.e. citrate and isocitrate.

The polyfunctional compound is present in the the toplayer in an amount between 2 mg/m² and 80 mg/m². Preferably the polyfunctional compound is present in the toplayer in an amount between 4 mg/m² and 50 mg/m². More preferably, the polyfunctional compound is present in the toplayer in an amount between 6 mg/m² and 30 mg/m². Most preferably, the polyfunctional compound is present in the toplayer in an amount between 8 mg/m² and 20 mg/m². The concentration of the polyfunctional compound should be sufficient to prevent toning - which especially occurs under humid conditions - and is preferably not too high to avoid a negative impact on the presslife.

The toplayer preferably further includes a hydrophobic polymer also referred to as the "hydrophobic binder". The hydrophobic polymer is preferably a halogenated polymer which includes at least one halogen. A hydrophobic polymer is a polymer which is preferably not soluble or swellable in water - i.e. at about neutral pH. The hydrophobic binder is preferably not cross-linked or only slightly cross-linked. The hydrophobic polymer is preferably in the form of particles. The hydrophobic polymer is preferably used in the toplayer in the form of a dispersion; i.e. an emulsion or suspension. Preferred is a dispersion of particles in an aqueous medium.

The hydrophobic binder in the toplayer displays a superior resistance against damages in the imaged areas as a result of plate handling compared to printing plates without such a binder in the toplayer. More details concerning the hydrophobic binder can be found in EP 3 587 113.

The average particle size is preferably comprised between 10 nm and 1000 nm, more preferably between 25 nm and 250 nm, even more preferably between 30 nm and 200 nm and most preferably between 50 nm and 175 nm. Herein, the particle size is defined as the particle diameter, measured by Photon Correlation Spectrometry, also known as Quasi-Elastic or Dynamic Light-Scattering. This technique is a convenient method for measuring the particle size and the values of the measured particle size match well with the particle size measured with transmission electronic microscopy (TEM) as disclosed by Stanley D. Duke et al. in Calibration of Spherical Particles by Light Scattering, in Technical Note-002B, May 15, 2000 (revised 1/3/2000 from a paper published in Particulate Science and Technology 7, p. 223-228 (1989).

The amount of the hydrophobic binder in the toplayer is preferably between 30%wt and 96%wt, more preferably between 40%wt and 90%wt and most preferably between 50%wt and 85%wt, relative to the total weight of the toplayer.

The hydrophobic binder preferably includes at least one monomeric unit derived from vinyl and/or vinylidene monomer; preferably vinylidene monomers. The hydrophobic binder may be a homopolymer or a copolymer. Copolymers are highly preferred. The copolymer is preferably a random copolymer, a gradient copolymer or a segmented copolymer. The segmented copolymer is preferably a block copolymer, a graft copolymer or a star polymer in which polymer chains are bonded to a core. Suitable examples of vinyl monomers include vinyl halides such as vinyl chloride, vinyl bromide or vinyl iodide. Suitable examples of vinylidene monomers include a halogen such as fluoride, chloride, bromide or iodide, i.e. vinylidene halides such as vinylidene fluoride, vinylidene chloride, vinylidene bromide or vinylidene iodide.

In a highly preferred embodiment, the hydrophobic binder includes at least one monomeric unit derived from a vinylidene monomer. Suitable vinylidene monomers include vinylidene halides such as vinylidene fluoride, vinylidene chloride, vinylidene bromide and/or vinylidene iodide. Most preferably the hydrophobic binder includes at least one monomeric unit derived from vinylidene fluoride and/or vinylidene chloride, most preferably from vinylidene chloride, also referred to herein as PVDC binder. The hydrophobic binder preferably includes between 60 %wt and 95 %wt monomeric units derived from vinylidene monomers, more preferably between 65%wt and 90%wt and most preferably between 70 and 85%wt.

It has been observed that the presence of the hydrophobic binder in the toplayer - which is preferably a particulate, non hygroscopic binder - increases the susceptibility of toning behaviour upon high humidity exposure. It was surprisingly found that the occurrence of this toning is highly reduced by including the polyfunctional compound according to the current invention in the toplayer.

The hydrophobic binder can be synthesized by conventionally known methods based on addition polymerisation. The numeric average molecular weight (Mn) of the polymers used in the present invention ranges preferably from 5.000 g/mol to 1.000.000 g/mol, more preferably from 10.000 g/mol to 500.000 g/mol and most preferably from 20.000 g/mol to 150.000 g/mol. The weight average molecular weight (Mw) of the polymers used in the present invention ranges preferably from 10.000 g/mol to 400.000 g/mol, more preferably from 70.000 g/mol to 350.000 g/mol and most preferably from 100.000 g/mol to 250.000 g/mol. The numeric average molecular weight (Mn) and the weight average molecular weight (Mw) are each determined by size exclusion chromatography using a mixture of THF and 5%wt acetic acid as eluent and polystyrene as calibration standards.

The hydrophobic binder used in the present invention is preferably a copolymer such as a gradient copolymer which exhibits a gradual change in monomer composition from predominantly one monomer to predominantly the other; or a random copolymer which has no continuous change in composition. The hydrophobic binder may comprise other monomeric units besides vinyl and/or vinylidene monomeric units as defined above. The hydrophobic binder preferably includes between 5 %wt and 40 %wt of these other monomeric units, more preferably between 10 %wt and 30 %wt and most preferably between 15%wt and 25%wt. All amounts of the monomeric unities, expressed herein as %wt, refer to the sum of all monomeric units of the copolymer. The other monomeric units are defined below.

The hydrophobic binder may further comprise one or more other monomeric units preferably derived from acrylate or methacrylate e.g. an alkyl or aryl (meth)acrylate such as methyl (meth)acrylate, ethyl (meth)acrylate, butyl (meth)acrylate, benzyl (meth)acrylate, 2-phenylethyl (meth)acrylate, hydroxylethyl (meth)acrylate, phenyl (meth)acrylate or N-(4-metylpyridyl)(meth)acrylate; (meth)acrylic acid; a (meth)acrylamide e.g. (meth)acrylamide or a N-alkyl or N-aryl (meth)acrylamide such as N-methyl (meth)acrylamide, N-ethyl (meth)acrylamide, N-phenyl (meth)acrylamide, N-benzyl (meth)acrylamide, N-methylol (meth)acrylamide, N-(4-hydroxyphenyl)(meth)acrylamide; (meth)acrylonitrile; styrene; a substituted styrene such as 2-, 3- or 4-hydroxy-styrene, 4-carboxy-styrene ester; a vinylpyridine such as 2-vinylpyridine, 3-vinylpyridine, 4-vinylpyridine; a substituted vinylpyridine such as 4-methyl-2-vinylpyridine; vinyl acetate, optionally the copolymerised vinyl acetate monomeric units are at least partially hydrolysed, forming an alcohol group, and/or at least partially reacted by an aldehyde compound such as formaldehyde or butyraldehyde, forming an acetal or butyral group; vinyl alcohol; vinyl nitrile; vinyl acetal; vinyl butyral; a vinyl ether such as methyl vinyl ether; vinyl amide; a N-alkyl vinyl amide such as N-methyl vinyl amide, caprolactame, vinyl pyrrolydone; maleic anhydride, a maleimide e.g. maleimide or a N-alkyl or N-aryl maleimide such as N-benzyl maleimide.

In a preferred embodiment, the binder further comprises monomeric units selected from (meth)acrylates such as methyl (meth)acrylate, ethyl(meth)acrylate, propyl (meth)acrylate, butyl(meth)acrylate or phenyl(meth)acrylate, hydroxyethyl (meth)acrylate or benzyl (meth)acrylate; vinyl nitrile or vinyl pyrrolidone.

The hydrophobic binder most preferably includes methyl acrylate units and/or butyl acrylate units.

Particularly preferred PVDC polymers are IxanTM and DiofanTM commercially available from Solvay, PVDC latex commercially available from Asahi-Kasei, DaranTM commercially available from Owensboro, PermaxTM commercially available from Lubrizol. Some of these copolymer grades are not waterbased but can be dispersed in water via different dispersion techniques well-known in the art in order to obtain a water based dispersion.

Other preferred binders which can be used in the top layer are disclosed in WO2005/029190 (page 36 line 3 to page 39 line 25), US 2007/0020563 (paragraph [0158]) and EP 1 288 720 (paragraphs [0148] and [0149]). Most preferred binders which can be used in the toplayer are polyvinyl alcohol or polyvinylalcohol/polyvinyl acetate copolymers. This copolymer preferably has a hydrolysis degree ranging between 74 mol % and 99 mol %, more preferably between 80-98%. The weight average molecular weight of the polyvinyl alcohol can be defined by measuring the viscosity of an aqueous solution, 4 % by weight, at 20°C as defined in DIN 53015, and this viscosity number (mPas) ranges preferably between 2 and 28, more preferably between 2 and 15, most preferably between 2 and 10. Modified polyvinylalcohols or polyvinylalcohol/polyvinyl acetate copolymers, e.g. polyvinylalcohols or copolymers including a carboxyl group and/or a sulphonic acid group may also be used, preferably together with unmodified polyvinylalcohols or polyvinylalcohol/polyvinyl acetate copolymers.

The toplayer may optionally include other ingredients such as inorganic or organic acids, matting agents, surfactants such as anionic surfactants, e.g. sodium alkyl sulphate or sodium alkyl sulphonate; amphoteric surfactants, e.g. alkylaminocarboxylate and alkylamino-dicarboxylate; non-ionic surfactants, e.g. polyoxyethylene alkyl phenyl ether, (co)polymers comprising siloxane and/or perfluoroalkyl units and/or oligo(alkylene oxide) units; fillers, (organic) waxes, alkoxylated alkylene diamines as for example disclosed in EP 1 085 380 (paragraph [0021] and [0022]), glycerine, inorganic particles, pigments or wetting agents as disclosed in EP 2 916 171 and are incorporated herein by reference.

The coating thickness of the toplayer is preferably between 0.10 and 1.75 g/m², more preferably between 0.20 and 1.3 g/m², most preferably between 0.25 and 1.0 g/m². In a more preferred embodiment of the present invention, the toplayer has a coating thickness between 0.25 and 1.75 g/m² and comprises a polyvinylalcohol having a hydrolysis degree ranging between 74 mol % and 99 mol % and a viscosity number as defined above ranging between 2 and 26 mPas.

### Colour precursor

The coating preferably includes a colour precursor which forms a coloured compound upon exposure to UV light, infrared light and/or heat whereby a print-out image is formed. The contrast of the print-out image may be defined as the difference between the optical density at the exposed area to the optical density at the non-exposed area, and is preferably as high as possible. This enables the end-user to establish immediately whether or not the precursor has been exposed, to distinguish the different colour selections and to inspect the quality of the image on the plate precursor. The contrast of the print-out image preferably increases with increasing optical density in the exposed areas and can be measured in reflectance using an optical densitometer, equipped with several filters (e.g. cyan, magenta, yellow). It has been observed that defects and/or oxidation spots on the surface of the aluminum support are much more visible when a colour precursor is present in the toplayer.

At least one colour precursor may be in the photopolymerisable layer and/or in the toplayer and/or in an optional other layer. The photopolymerisable layer, the toplayer and optionally another layer may include the same or different colour precursors. Preferably, the colour precursor is present in the toplayer.

A number of classes of colour precursors may be used as colour forming compounds in the present invention, such as for example: spiropyran leuco dyes such as spirobenzopyrans (e.g. spiroindolinobenzopyrans, spirobenzo-pyranobenzopyrans, 2,2-dialkylchromenes), spironaphtooxazine and spirothiopyran; leuco quinone dyes; azines such as oxazines, diazines, thiazines and phenazine; phthalide- and phthalimidine-type leuco dyes such as triarylmethane phtalides (e.g. crystal violet lactone), diarylmethane phthalides, monoarylmethane phthalides, heterocyclic substituted phthalides, alkenyl substituted phthalides, bridged phthalides (e.g. spirofluorene phthalides and spirobenzanthracene phthalides) and bisphthalides; fluoran leuco dyes such as fluoresceins, rhodamines and rhodols; triarylmethanes such as leuco crystal violet; ketazines; barbituric acid leuco dyes and thiobarbituric acid leuco dyes. Specific colour precursors which are suitable to form a coloured dye upon exposure with heat and/or light are disclosed in WO2019/243037 [0035] to [0060].

The colour precursor may be present in the toplayer in an amount of 0.01 to 0.1 g/m², more preferably in an amount of 0.02 to 0.08 g/m2, most preferably in an amount of 0.025 to 0.05 g/m2.

Highly preferred colour precursors are IR-leuco dyes, also called herein as IR-thermochromic dyes or infrared-thermochromic dyes, which have a main absorption in the infrared wavelength range of the electromagnetic spectrum - i.e. a wavelength range between about 750 and 1500nm - and preferably do not have a substantial light absorption in the visible wavelength range of the electromagnetic spectrum - i.e. a wavelength range between 390 and 700nm. Preferred IR-thermochromic dyes are disclosed in EP 1 736 312 and EP 1 910 082 and have a partial structure according to the following formula: 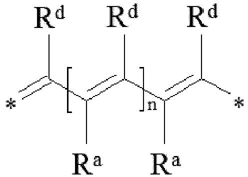 wherein * denotes links of the partial structure to the rest of the structure and wherein at least one of the R^{d} groups is a group which is transformed by a chemical reaction, induced by exposure to IR radiation or heat, into a group which is a stronger electron-donor than said R^{d}; or wherein at least one of the R^{a} groups is a group which is transformed by a chemical reaction, induced by exposure to IR-radiation or heat, into a group which is a stronger electron acceptor than said R^{a}. The latter dyes are for example disclosed in EP 1 176 007. An electron accepting group is preferably defined as having a Hammett sigma para-value more than or equal to 0.3 and an electron donor group as having a Hammett sigma para-value less than or equal to 0.3. Details concerning sigma para-values can be found in Chapman and Shorter, Correlation Analysis in Chemistry, Recent Advances, Plenum, New York, 1978, p.439-540.

The IR-thermochromic dye preferably includes at least one thermocleavable group which is transformed by a chemical reaction, induced by exposure to IR radiation or heat, into a group which is a stronger electron-donor. As a result, the exposed IR-thermochromic dye absorbs substantially more light in the visible wavelength range of the electromagnetic spectrum, or in other words, the IR-thermochromic dye undergoes a hypsochromic shift whereby a visible image is formed, also referred to as print-out image.

The concentration of the IR-thermochromic dye with respect to the total dry weight of the coating, may be from 0.1 %wt to 20.0 %wt, more preferably from 0.5 %wt to 15.0 %wt, most preferred from 1.0 %wt to 10.0 %wt.

The IR-thermochromic dye is preferably represented by Formulae I, II or III: 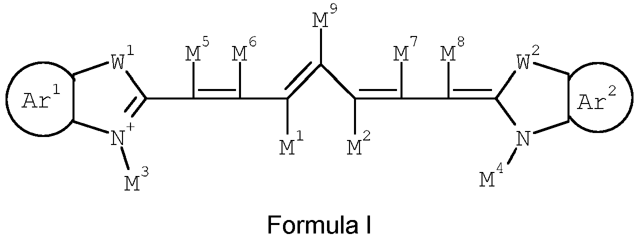 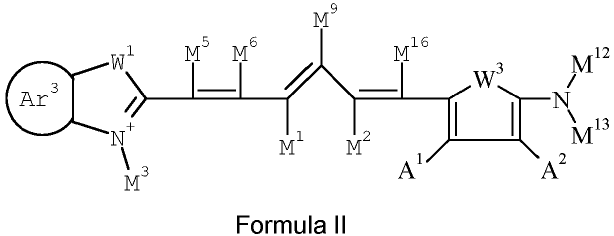 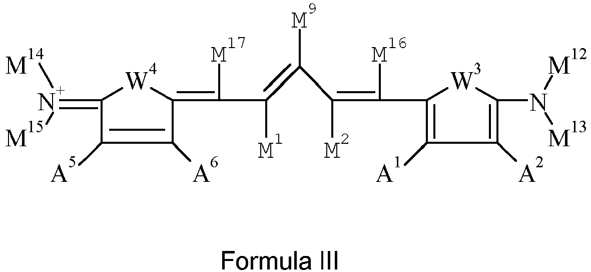 wherein
Ar¹, Ar² and Ar³ independently represent an optionally substituted aromatic hydrocarbon group or an aromatic hydrocarbon group with an annulated benzene ring which is optionally substituted,
W¹ and W² independently represent a sulphur atom, an oxygen atom, NR" wherein R" represents an optionally substituted alkyl group, NH, or a - CM¹⁰M¹¹ group wherein M¹⁰ and M¹¹ are independently an optionally substituted aliphatic hydrocarbon group or an optionally substituted (hetero)aryl group, or wherein M¹⁰ and M¹¹ together comprise the necessary atoms to form a cyclic structure, preferably a 5- or 6-membered ring;
W³ represent a sulphur atom or a -C(A³)=C(A⁴)-group,
W⁴ represents a sulphur atom or a -C(A⁷)=C(A⁸)-group,
M¹ and M² independently represent hydrogen, an optionally substituted aliphatic hydrocarbon group or together comprise the necessary atoms to form an optionally substituted cyclic structure, preferably M¹ and M² together comprise the necessary atoms to form an optionally substituted cyclic structure which may comprise an optionally substituted annulated benzene ring, preferably a 5- or 6-membered ring, more preferably a 5-membered ring, most preferably a 5-membered ring having a cyclic structure of 5 carbon atoms;
M³ and M⁴ independently represent an optionally substituted aliphatic hydrocarbon group;
M⁵, M⁶, M⁷ and M^{$} , M¹⁶ and M¹⁷ independently represent hydrogen, a halogen or an optionally substituted aliphatic hydrocarbon group,
A¹ to A⁸ independently represent hydrogen, a halogen atom, an optionally substituted aliphatic hydrocarbon group or an optionally substituted (hetero)aryl group, or wherein each of A¹ and A², A³ and A⁴, A⁵ and A⁶, or, A⁷ and A⁸, together comprise the necessary atoms to form a cyclic structure, preferably 5- or 6-membered ring;
M¹² and M¹³ and M¹⁴ and M¹⁵ independently represent an optionally substituted aliphatic hydrocarbon group or an optionally substituted (hetero)aryl group, or wherein, two of said M¹⁴, M¹⁵, A⁵ or A⁷ together comprise the necessary atoms to form at least one cyclic structure, preferably 5- or 6-membered ring; two of said M¹², M¹³, A² or A⁴ together comprise the necessary atoms to form at least one cyclic structure preferably 5- or 6-membered ring;
M⁹ is a group which is transformed by a chemical reaction, induced by exposure to IR radiation or heat, into a group which is a stronger electron-donor than said M⁹; and said transformation provides an increase of the integrated light absorption of said dye between 350 and 750nm; and optionally one or more counter ions in order to obtain an electrically neutral compound.

The IR-thermochromic dye can be a neutral, an anionic or a cationic dye depending on the type of the substituting groups and the number of each of the substituting groups. In a preferred embodiment, the IR-thermochromic dye of formula I, II or III comprises at least one anionic or acid group such as -CO₂H, -CONHSO₂R^{h}, -SO₂NHCORⁱ, -SO₂NHSO₂R^{j}, -PO₃H₂, -OPO₃H₂, -OSO₃H, -S-SO₃H or -SO₃H groups or their corresponding salts, wherein R^{h}, Rⁱ and R^{j} are independently an aryl or an alkyl group, preferably a methyl group, and wherein the salts are preferably alkali metal salts or ammonium salts, including mono- or di- or tri- or tetra-alkyl ammonium salts. These anionic or acid groups may be present on the aromatic hydrocarbon group or the annulated benzene ring of Ar¹, Ar² or Ar³, or on the aliphatic hydrocarbon group of M³, M⁴ or M¹² to M¹⁵, or on the (hetero)aryl group of M¹² to M¹⁵. Other substituting groups can be selected from a halogen atom, a cyano group, a sulphone group, a carbonyl group or a carboxylic ester group. In another preferred embodiment, at least one of M³, M⁴ or M¹² to M¹⁵ is terminally substituted with at least one of these groups, more preferably with -CO₂H, -CONHSO₂-Me, -SO₂NHCO-Me, -SO₂NHSO₂-Me, -PO₃H₂ or -SO₃H groups or their corresponding salt, wherein Me represents a methyl group.

In a preferred embodiment, the IR-thermochromic dye represented by Formulae I, II or III above includes M⁹ represented by one of the following groups:

-(N=CR¹⁷)a -NR⁵-CO-R⁴,

-(N=CR¹⁷)b -NR⁵-SO₂-R⁶,

-(N=CR¹⁷)c -NR¹¹-SO-R¹²,

-SO₂-NR¹⁵R¹⁶ and

-S-CH₂-CR⁷(H)_{1-d}(R⁸)_{d} -NR⁹-COOR¹⁸,

wherein
a, b, c and d independently are 0 or 1;
R¹⁷ represents hydrogen, an optionally substituted aliphatic hydrocarbon group or an optionally substituted (hetero)aryl group, or wherein R¹⁷ and R⁵ or R¹⁷ and R¹¹ together comprise the necessary atoms to form a cyclic structure;
R⁴ represents -OR¹⁰, -NR¹³R¹⁴ or -CF₃;
wherein R¹⁰ represents an optionally substituted (hetero)aryl group or an optionally branched aliphatic hydrocarbon group;
R¹³ and R¹⁴ independently represent hydrogen, an optionally substituted aliphatic hydrocarbon group or an optionally substituted (hetero)aryl group, or wherein R¹³ and R¹⁴ together comprise the necessary atoms to form a cyclic structure;
R⁶ represents an optionally substituted aliphatic hydrocarbon group or an optionally substituted (hetero)aryl group, -OR¹⁰, -NR¹³R¹⁴ or -CF₃;
R⁵ represents hydrogen, an optionally substituted aliphatic hydrocarbon group, a SO₃- group, a -COOR¹⁸ group or an optionally substituted (hetero)aryl group, or wherein R⁵ together with at least one of R¹⁰, R¹³ and R¹⁴ comprise the necessary atoms to form a cyclic structure;
R¹¹, R¹⁵ and R¹⁶ independently represent hydrogen, an optionally substituted aliphatic hydrocarbon group or an optionally substituted (hetero)aryl group, or wherein R¹⁵ and R¹⁶ together comprise the necessary atoms to form a cyclic structure;
R¹² represents an optionally substituted aliphatic hydrocarbon group or an optionally substituted (hetero)aryl group;
R⁷ and R⁹ independently represent hydrogen or an optionally substituted aliphatic hydrocarbon group;
R⁸ represents -COO- or -COOR^{8'} wherein R^{8'} represents hydrogen, an alkali metal cation, an ammonium ion or a mono-, di-, tri- or tetra-alkyl ammonium ion;
R¹⁸ represents an optionally substituted (hetero)aryl group or an alpha-branched aliphatic hydrocarbon group.

Suitable examples of IR-thermochromic dyes used in the present invention are described in EP 1 910 082 pages 4 to 8, IRD-001 to IRD-101, and incorporated herein by reference.

In a highly preferred embodiment, the IR-thermochromic dye is represented by Formula I 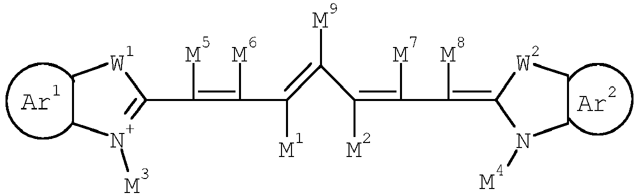 wherein Ar¹, Ar², W¹, W² and M¹ to M⁹ are as defined above.

Most preferably the IR-thermochromic dye is represented by Formula I wherein Ar¹ and Ar² independently represent an optionally substituted aryl group; optionally annulated with an optionally substituted benzene ring, W¹ and W² represent -C(CH₃)₂; M¹ and M² together comprise the necessary atoms to form an optionally substituted 5-membered ring which may comprise an optionally substituted annulated benzene ring; M³ and M⁴ independently represent an optionally substituted aliphatic hydrocarbon group, M⁵, M⁶, M⁷ and M⁸ represent hydrogen; M⁹ represents

-NR⁵-CO-R⁴

-NR⁵-SO₂-R⁶

-NR¹¹-SO-R¹²

-SO₂-NR¹⁵R¹⁶

wherein R⁴, R⁵, R⁶, R¹¹, R¹², R¹⁵, and R¹⁶ are as defined above; and optionally one or more counter ions in order to obtain an electrically neutral compound. Preferably the IR dye comprises at least one anionic group or an acid group, such as -CO₂H, -CONHSO₂R^{h}, -SO₂NHCORⁱ, - SO₂NHSO₂R^{j},-PO₃H₂, -OPO₃H₂, -OSO₃H, -SO₃H or -S-SO₃H groups or their corresponding salts, wherein R^{h}, Rⁱ and R^{j} are independently an aryl or an alkyl group. More preferably, at least one of the aliphatic hydrocarbon groups of M³ or M⁴ is terminally substituted with at least one of said anionic groups or acid groups.

In a highly preferred embodiment the IR-thermochromic dye is represented by Formula I wherein
Ar¹ and Ar² independently represent an optionally substituted aryl group;
W¹ and W² represent -C(CH₃)₂;
M¹ and M² together comprise the necessary atoms to form an optionally substituted 5-membered ring which may comprise an optionally substituted annulated benzene ring;
M³ and M⁴ independently represent an optionally substituted aliphatic hydrocarbon group,
M⁵, M⁶, M⁷ and M⁸ represent hydrogen;
M⁹ represents

   -NR⁵-CO-R⁴

   -NR⁵-SO₂-R⁶

   wherein
   R⁴ is -OR¹⁰, wherein R¹⁰ is an optionally branched aliphatic hydrocarbon group;
   R⁵ represents hydrogen, an optionally substituted aliphatic hydrocarbon group or an optionally substituted (hetero)aryl group,
   R⁶ represents an optionally substituted aliphatic hydrocarbon group or an optionally substituted (hetero)aryl group; and optionally one or more counter ions in order to obtain an electrically neutral compound.

Preferably the IR dye comprises at least one anionic group or an acid group, such as -CO₂H, -CONHSO₂R^{h}, -SO₂NHCORⁱ, -SO₂NHSO₂R^{j},-PO₃H₂, -OPO₃H₂, -OSO₃H, -SO₃H or -S-SO₃H groups or their corresponding salts, wherein R^{h}, Rⁱ and R^{j} are independently an aryl or an alkyl group. More preferably, at least one of the aliphatic hydrocarbon groups of M³ or M⁴ is terminally substituted with at least one of said anionic groups or acid groups. The salts are preferably alkali metal salts or ammonium salts, including mono- or di- or tri- or tetra-alkyl ammonium salts.

The optional counter ions in order to obtain an electrically neutral compound may be selected from for example a halogen, a sulphonate, a perfluorosulphonate, a tosylate, a tetrafluoroborate, a hexafluorophosphate, an arylborate, an arylsulphonate; or a cation such as alkali metal salts or ammonium salts, including mono- or di- or tri- or tetra-alkyl ammonium salts.

Especially preferred IR-thermochromic dyes are presented by one of the following formulae IV to XI: 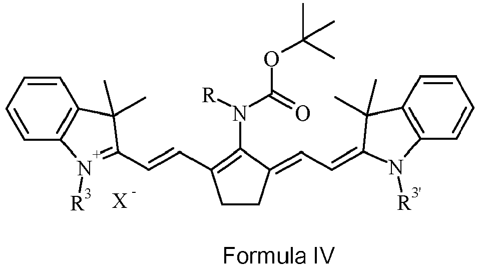 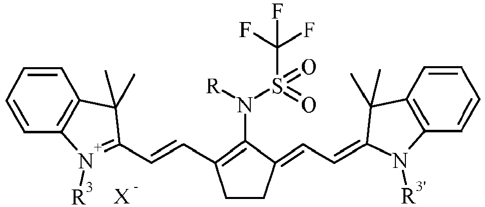 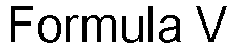 wherein
X- represents halogen, sulphonate, perfluorosulphonate, tosylate, tetrafluoroborate, hexafluorophosphate, aryl borate or arylsulphonate; and
R³, R^{3'} independently represent an optionally substituted alkyl group, preferably a methyl or ethyl; or an ether group, preferably -CH₂-CH₂-O-CH_{3;} 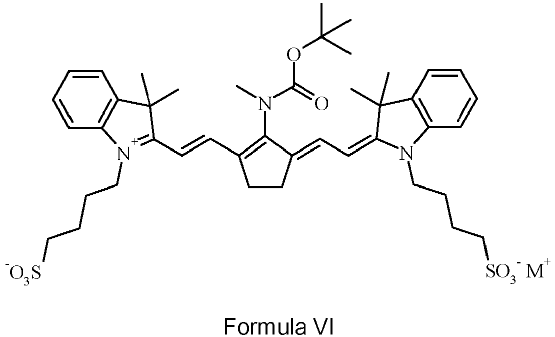 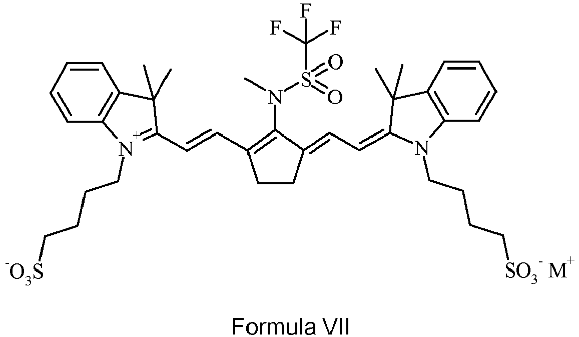 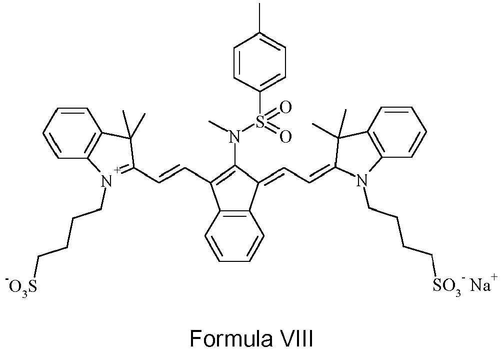 wherein
   M⁺ = Li⁺, Na⁺, K⁺, NH₄⁺, R'R"R‴NH⁺ wherein R', R", R‴ independently represent hydrogen, an optional substituted alkyl or aryl group.

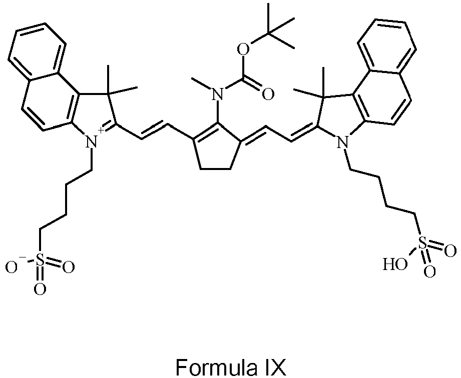

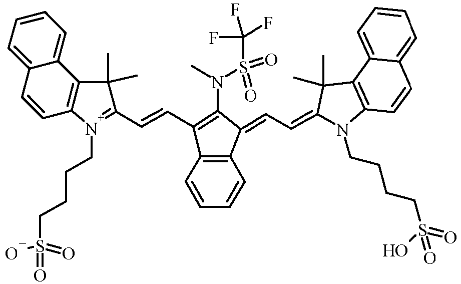

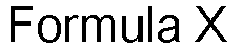

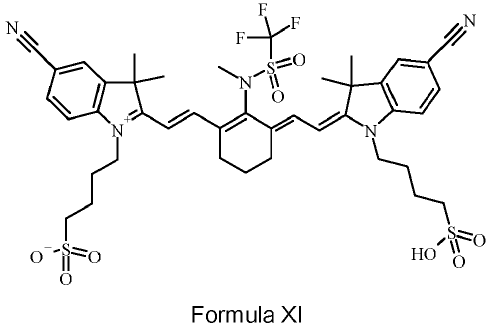

### Definitions

An aliphatic hydrocarbon group preferably represents an alkyl, cycloalkyl, alkenyl, cyclo alkenyl or alkynyl group; suitable groups thereof are described below. An aromatic hydrocarbon group preferably represents a hetero(aryl) group; suitable hetero(aryl) groups - i.e. suitable aryl or heteroaryl groups - are described below.

The term "alkyl" herein means all variants possible for each number of carbon atoms in the alkyl group i.e. methyl, ethyl, for three carbon atoms:
n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc. Examples of suitable alkyl groups are methyl, ethyl, n-propyl, isopropyl, n-butyl, 1-isobutyl, 2-isobutyl and tertiary-butyl, n-pentyl, n-hexyl, chloromethyl, trichloromethyl, iso-propyl, iso-butyl, iso-pentyl, neo-pentyl, 1-methylbutyl and iso-hexyl, 1,1-dimethyl-propyl, 2,2-dimethylpropyl and 2-methyl-butyl, cyclopropyl, cyclobutyl, cyclopentyl, cyclohexyl and methylcyclohexyl groups. Preferably, the alkyl group is a C₁ to C₆-alkyl group.

A suitable alkenyl group is preferably a C₂ to C₆-alkenyl group such as an ethenyl, n-propenyl, n-butenyl, n-pentenyl, n-hexenyl, iso-propenyl, isobutenyl, iso-pentenyl, neo-pentenyl, 1-methylbutenyl, iso-hexenyl, cyclopentenyl, cyclohexenyl and methylcyclohexenyl group.

A suitable alkynyl group is preferably a C2 to C6-alkynyl group; a suitable aralkyl group is preferably a phenyl group or naphthyl group including one, two, three or more C₁ to C₆-alkyl groups; a suitable alkaryl group is preferably a C₁ to C₆-alkyl group including an aryl group, preferably a phenyl group or naphthyl group.

A cyclic group or cyclic structure includes at least one ring structure and may be a monocyclic- or polycyclic group, meaning one or more rings fused together.

Examples of suitable aryl groups may be represented by for example an optionally substituted phenyl, benzyl, tolyl or an ortho- meta- or para-xylyl group, an optionally substituted naphtyl, anthracenyl, phenanthrenyl, and/or combinations thereof. The heteroaryl group is preferably a monocyclic or polycyclic aromatic ring comprising carbon atoms and one or more heteroatoms in the ring structure, preferably, 1 to 4 heteroatoms, independently selected from nitrogen, oxygen, selenium and sulphur. Preferred examples thereof include an optionally substituted furyl, pyridinyl, pyrimidyl, pyrazoyl, imidazoyl, oxazoyl, isoxazoyl, thienyl, tetrazoyl, thiazoyl, (1,2,3)triazoyl, (1,2,4)triazoyl, thiadiazoyl, thiofenyl group and/or combinations thereof.

A cyclic group or cyclic structure includes at least one ring structure and may be a monocyclic- or polycyclic group, meaning one or more rings fused together.

Halogens are selected from fluorine, chlorine, bromine or iodine.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

The optional substituents on the alkyl, cycloalkyl, alkenyl, cycloalkenyl, alkynyl, aralkyl, alkaryl, aryl and heteroaryl group are preferably selected from hydroxy, -Cl, -Br, -I, -OH, -SH, -CN, -NO₂, an alkyl group such as a methyl or ethyl group, an alkoxy group such as a methoxy or an ethoxy group, an aryloxy group, a carboxylic acid group or an alkyl ester thereof, a sulphonic acid group or an alkyl ester thereof, a phosphonic acid group or an alkyl ester thereof, a phosphoric acid group or an an ester such as an alkyl ester such as methyl ester or ethyl ester, a thioalkyl group, a thioaryl group, thioheteroaryl, -SH, a thioether such as a thioalkyl or thioaryl, ketone, aldehyde, sulfoxide, sulfone, sulfonate ester, sulphonamide, an amino, ethenyl, alkenyl, alkynyl, cycloalkyl, alkaryl, aralkyl, aryl, heteroaryl or heteroalicyclic group and/or combinations thereof.

### Support

The lithographic printing plate used in the present invention comprises a support which has a hydrophilic surface or which is provided with a hydrophilic layer. The support is preferably a grained and anodized aluminium support, well known in the art. Suitable supports are for example disclosed in EP 1 843 203 (paragraphs [0066] to [0075]). The surface roughness, obtained after the graining step, is often expressed as arithmetical mean center-line roughness Ra (ISO 4287/1 or DIN 4762) and may vary between 0.05 and 1.5 µm. The aluminum substrate of the current invention has preferably an Ra value between 0.1 and 1.4 µm, more preferably between 0.3 and 1.0 µm and most preferably between 0.4 and 0.9 µm. The lower limit of the Ra value is preferably about 0.1 µm. More details concerning the preferred Ra values of the surface of the grained and anodized aluminum support are described in EP 1 356 926. By anodising the aluminum support, an Al₂O₃ layer is formed and the anodic weight (g/m² Al₂O₃ formed on the aluminum surface) varies between 1 and 8 g/m². The anodic weight is preferably ≥ 2.0 g/m², more preferably ≥ 2.5 g/m² and most preferably ≥ 3.0 g/m².

The grained and anodized aluminium support may be subjected to so-called post-anodic treatments, for example a treatment with polyvinylphosphonic acid or derivatives thereof, a treatment with polyacrylic acid or derivatives thereof, a treatment with potassium fluorozirconate or a phosphate, a treatment with an alkali metal silicate, or combinations thereof. Enlargement or sealing of micropores of the anodized aluminum as disclosed in JP2001-253181A or JP2001-322365A may be performed. Treatment of the edges of the support as described in for example US 2017/320351 may be of interest to prevent occurrence of printing edges. Alternatively, the support may be treated with an adhesion promoting compound such as those described in EP 1 788 434 in [0010] and in WO 2013/182328. However, for a precursor optimized to be used without a pre-heat step it is preferred to use a grained and anodized aluminium support without any post-anodic treatment.

Besides an aluminium support, a plastic support, for example a polyester support, provided with one or more hydrophilic layers as disclosed in for example EP 1 025 992 may also be used.

### Photopolymer coating

### Photopolymerisable compound

The coating has at least one layer including a photopolymerisable composition, said layer is also referred to as the "photopolymerisable layer". The coating may include an intermediate layer, located between the support and the photopolymerisable layer.

The photopolymerisable layer includes at least one polymerisable compound and optionally a binder. The photopolymerisable layer has a coating thickness preferably ranging between 0.2 and 5.0 g/m2, more preferably between 0.4 and 3.0 g/m2, most preferably between 0.6 and 2.2 g/m2.

According to a preferred embodiment of the present invention, the polymerisable compound is a polymerisable monomer or oligomer including at least one terminal ethylenic unsaturated group, hereinafter also referred to as "free-radical polymerisable monomer". The polymerisation involves the linking together of the free-radical polymerisable monomers. Suitable free-radical polymerisable monomers include, for example, mono- or multifunctional (meth)acrylate monomers (such as (meth)acrylate esters of ethylene glycol, trimethylolpropane, pentaerythritol, ethylene glycol, ethoxylated trimethylolpropane, urethane (meth)acrylate) and oligomeric amine diacrylates. The (meth)acrylic monomers may also have other ethylenically unsaturated groups or epoxide groups in addition to the (meth)acrylate group. The (meth)acrylate monomers may also contain an acidic (such as a carboxylic acid or phosphoric acid) or basic (such as an amine) functionality.

Suitable free-radical polymerisable monomers are disclosed in [0042] and [0050] of EP 2 916 171 and are incorporated herein by reference.

### The initiator

Any free radical initiator capable of generating free radicals upon exposure directly or in the presence of a sensitizer, is according to this invention a suitable initiator. Suitable examples of initiators include onium salts, carbon-halogen bond-containing compounds such as [1,3,5] triazines having trihalomethyl groups, organic peroxides, aromatic ketones, thio compounds, azo based polymerization initiators, azide compounds, ketooxime esters, hexaarylbisimidazoles, metallocenes, active ester compounds, borates and quinonediazides. Of these, onium salts, especially iodonium and/or sulfonium salts are preferable in view of storage stability.

More specific suitable free-radical initiators include, for example, the derivatives of acetophenone (such as 2,2-dimethoxy-2-phenylacetophenone, and 2-methyl-l-[4-(methylthio) phenyll-2-morpholino propan-l-one); benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate, (4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238,6,037,098, and 5,629,354); borate salts (such as tetrabutylammonium triphenyl(n-butyl)borate, tetraethylammonium triphenyl(n-butyl)borate, diphenyliodonium tetraphenylborate, and triphenylsulfonium triphenyl(n-butyl)borate, and borate salts as described in U.S. Pat. Nos. 6,232,038 and 6,218,076,); haloalkyl substituted s-triazines (such as 2,4-bis(trichloromethyl)-6-(p-methoxy-styryl)-s-triazine, 2,4-bis(trichloromethyl)-6-(4-methoxy-naphth-l-yl)-s-triazine, 2,4-bis(trichloromethyl)-6-piperonyl-s- triazine, and 2,4-bis(trichloromethyl)-6-[(4 -ethoxy-ethylenoxy)-phen-1-yl]-s-triazine, and s-triazines as described in U.S. Pat. Nos. 5,955,238, 6,037,098, 6,010,824 and 5,629,354); and titanocene (bis(etha.9-2,4-cyclopentadien-1-yl) bis[2,6-difluoro-3-(IH-pyrrol-1-yl)phenyl) titanium). Onium salts, borate salts, and s-triazines are preferred free radical initiators. Diaryliodonium salts and triarylsulfonium salts are preferred onium salts. Triarylalkylborate salts are preferred borate salts. Trichloromethyl substituted s-triazines are preferred s-triazines. These initiators may be used alone or in combination.

Optionally substituted trihaloalkyl sulfones wherein halo independently represents bromo, chloro or iodo and sulfone is a chemical compound containing a sulfonyl functional group attached to two carbon atoms, are particularly preferred initiators. Tribromomethyl phenyl sulfones are most preferred initiators. More details concerning this initiator can be found in unpublished copending application EP 18163285.2 paragraphs [0029] to [0040].

The amount of the initiator typically ranges from 0.1 to 30 % by weight, preferably from 0.5 to 15 % by weight, most preferably from 2 to 10 % by weight relative to the total weight of the non volatile components of the photopolymerisable composition.

A very high sensitivity can be obtained by the combination of an optical brightener as sensitizer and a polymerisation initiator.

The photopolymerisable layer may also comprise a co-initiator. Typically, a co-initiator is used in combination with a free radical initiator. Suitable co-initiators for use in the photopolymer coating are disclosed in US 6,410,205; US 5,049,479; EP 1 079 276, EP 1 369 232, EP 1 369 231, EP 1 341 040, US 2003/0124460, EP 1 241 002, EP 1 288 720 and in the reference book including the cited refences: Chemistry & Technology UV & EB formulation for coatings, inks & paints - Volume 3 -Photoinitiators for Free Radical and Cationic Polymerisation by K.K. Dietliker- Edited by P.K.T. Oldring - 1991 - ISBN 0 947798161. Specific co-initiators, as described in EP 107 792, may be present in the photopolymerizable layer to further increase the sensitivity. Preferred co-initiators are disclosed in EP 2 916 171 [0051] and are incorporated herein by reference.

A very high sensitivity can be obtained by including a sensitizer such as for example an optical brightener in the coating. Suitable examples of optical brighteners as sensitizers are described in WO 2005/109103 page 24, line 20 to page 39. Useful sensitizers can be selected from the sensitizing dyes disclosed in US 6,410,205; US 5,049,479; EP 1 079 276, EP 1 369 232, EP 1 369 231, EP 1 341 040, US 2003/0124460, EP 1 241 002 and EP 1 288 720.

Specific co-initiators, as described in EP 107 792, may be present in the photopolymerizable layer to further increase the sensitivity. Preferred co-initiators are sulfur-compounds, especially thiols like e.g. 2-mercaptobenzothiazole, 2-mercaptobenzoxazole, 2-mercaptobenzimidazole, 4-methyl-3-propyl-1,2,4-triazoline-5-thione, 4-methyl-3-n-heptyl-1,2,4-triazoline-5-thione, 4-phenyl-3-n-heptyl-1,2,4-triazoline-5-thione, 4-phenyl-3,5-dimercapto-1,2,4-triazole, 4-n-decyl-3,5-dimercapto-1,2,4-triazole, 5-phenyl-2-mercapto-1,3,4-oxadiazole, 5-methylthio-1,3,4-thiadiazoline-2-thione, 5-hexylthio-1,3,4-thiadiazoline-2-thione, mercaptophenyltetrazole, pentaerythritol mercaptopropionate, butyric acid-3-mercapto-neopentanetetrayl ester, pentaerythritol tetra(thioglycolate). Other preferred co-initiators are polythioles as disclosed in WO 2006/048443 and WO 2006/048445. These polythiols may be used in combination with the above described thiols, e.g. 2-mercaptobenzothiazole.

The photopolymerizable layer may optionally include violet or infrared light absorbing dyes as sensitizers. Infrared light absorbing dyes absorb light between 750 nm and 1300 nm, preferably between 780 nm and 1200 nm, more preferably between 800 nm and 1100 nm. Particular preferred sensitizers are heptamethinecyanine dyes disclosed in EP 1 359 008 paragraph [0030] to [0032].

### The binder

The photopolymerizable layer preferably includes a binder. The binder can be selected from a wide series of organic polymers. Compositions of different binders can also be used. Useful binders are described in for example EP 1 043 627 in paragraph [0013], WO2005/111727 page 17 line 21 to page 19 line 30 and in WO2005/029187 page 16 line 26 to page 18 line 11.

The PVDC binder as described above may optionally be present in the photopolymerizable layer.

The photopolymerizable layer may include discrete particles, i.e. particulate shaped polymers including homopolymers or copolymers prepared from monomers such as ethylene, styrene, vinyl chloride, methyl acrylate, ethyl acrylate, methyl methacrylate, ethyl methacrylate, acrylonitrile, vinyl carbazole, acrylate or methacrylate, or mixtures thereof. Preferably the discrete particles are particles which are suspended in the polymerisable composition. The presence of discrete particles tends to promote developability of the unexposed areas.

Thermally reactive polymer fine particles including a thermally reactive group such as an ethylenically unsaturated group, a cationic polymerizable group, an isocyanate group, an epoxy group, a vinyloxy group, and a functional group having an active hydrogen atom, a carboxy group, a hydroxy group, an amino group or an acid anhydride.

Specific examples of the polymeric binders according to this embodiment are described in US 6,899,994; US 2004/0260050, US 2005/0003285, US 2005/0170286, US 2005/0123853 and EP 2 916 171 in [0029], [0030] and [0031]. Other suitable binders as described in EP 2 471 655, EP 2 492 748 and EP 2 660 068 include multifunctional thiols having 6 to 10 functional groups as a nucleus (central skeleton) and polymer chains connected to the nucleus through sulfide bonds. In addition to the polymeric binder of this embodiment the imageable layer may optionally comprise one or more co-binders. Typical co-binders are water-soluble or water-dispersible polymers, such as, cellulose derivatives, polyvinylalcohol, polyacrylic acid poly(meth)acrylic acid, polyvinylpyrrolidone, polylactide, polyvinylphosphonic acid, synthetic co-polymers, such as co-polymers of an alkoxy polyethylene glycol (meth)acrylate. Specific examples of co-binders are described in US 2004/0260050, US 2005/0003285 and US 2005/0123853. Printing plate precursors, the imageable layer of which comprises a binder and optionally a co-binder according this embodiment and described in more detail in US 2004/0260050, US 2005/0003285 and US 2005/0123853.

The average particle diameter of the polymer fine particle is preferably 0.01 mm to 3.0 mm. Particulate polymers in the form of microcapsules, microgels or reactive microgels are suitable as disclosed in EP 1 132 200; EP 1 724 112 and US 2004/106060.

### Other ingredients

The photopolymerisable layer may also comprise particles which increase the resistance of the coating against manual or mechanical damage. The particles may be inorganic particles, organic particles or fillers such as described in for example US 7,108,956. More details of suitable spacer particles described in EP 2 916 171 [0053] to [0056] are incorporated herein by reference.

The photopolymerizable layer may also comprise an inhibitor. Particular inhibitors for use in the photopolymer coating are disclosed in US 6,410,205, EP 1 288 720 and EP 1 749 240.

The photopolymerizable layer may further comprise an adhesion promoting compound. The adhesion promoting compound is a compound capable of interacting with the support, preferably a compound having an addition-polymerizable ethylenically unsaturated bond and a functional group capable of interacting with the support. Under "interacting" is understood each type of physical and/or chemical reaction or process whereby, between the functional group and the support, a bond is formed which can be a covalent bond, an ionic bond, a complex bond, a coordinate bond or a hydrogen-bond, and which can be formed by an adsorption process, a chemical reaction, an acid-base reaction, a complex-forming reaction or a reaction of a chelating group or a ligand. The adhesion promoting compounds described in EP 2 916 171 [0058] are incorporated herein by reference.

Various surfactants may be added into the photopolymerisable layer to allow or enhance the developability of the precursor; especially developing with a gum solution. Both polymeric and small molecule surfactants for example nonionic surfactants are preferred. More details are described in EP 2 916 171 [0059] and are incorporated herein by reference.

### Exposure step

The printing plate precursor is preferably image-wise exposed off-press in a platesetter, i.e. an exposure apparatus suitable for image-wise exposing the precursor with a laser such as a laser diode, emitting around 830 nm or a Nd YAG laser emitting around 1060 nm, a violet laser, emitting around 400 nm, or a gas laser such as an Ar laser, or with a digitally modulated UV-exposure set-up, using e.g. digital mirror devices, or by a conventional exposure in contact with a mask. In a preferred embodiment of the present invention, the precursor is image-wise exposed by a laser emitting IR light or violet light, more preferably by a laser emitting IR light.

### Preheat step

After the exposing step, the precursor may be pre-heated in a preheating unit, preferably at a temperature of about 80°C to 150°C and preferably during a dwell time of about 5 seconds to 1 minute. This preheating unit may comprise a heating element, preferably an IR-lamp, an UV-lamp, heated air or a heated roll. Such a preheat step can be used for printing plate precursors comprising a photopolymerisable composition to enhance or to speed-up the polymerization and/or crosslinking reaction.

### Development step

Subsequently to the exposing step or the preheat step, when a preheat step is present, the plate precursor may be processed (developed). Before developing the imaged precursor, a pre-rinse step might be carried out especially for the negative-working lithographic printing precursors having a protective oxygen barrier or topcoat. This pre-rinse step can be carried out in a stand-alone apparatus or by manually rinsing the imaged precursor with water or the pre-rinse step can be carried out in a washing unit that is integrated in a processor used for developing the imaged precursor. The washing liquid is preferably water, more preferably tap water. More details concerning the wash step are described in EP 1 788 434 in [0026].

During the development step, the non-exposed areas of the image-recording layer are at least partially removed without essentially removing the exposed areas. The processing liquid, also referred to as developer, can be applied to the plate e.g. by rubbing with an impregnated pad, by dipping, immersing, coating, spincoating, spraying, pouring-on, either by hand or in an automatic processing apparatus. The treatment with a processing liquid may be combined with mechanical rubbing, e.g. by a rotating brush. During the development step, any water-soluble protective layer present is preferably also removed. The development is preferably carried out at temperatures between 20 and 40 °C in automated processing units.

In a highly preferred embodiment, the processing step as described above is replaced by an on-press processing whereby the imaged precursor is mounted on a press and processed on-press by rotating said plate cylinder while feeding dampening liquid and/or ink to the coating of the precursor to remove the unexposed areas from the support. In a preferred embodiment, supply of dampening liquid and ink is started simultaneously, or only ink can be supplied during a number of revolutions before switching on the supply of dampening liquid. In an alternative embodiment, only dampening liquid is supplied to the plate during start-up of the press and after a number of revolutions of the plate cylinder also the ink supply is switched on.

The processing step may also be performed by combining embodiments described above, e.g. combining development with a processing liquid with development on-press by applying ink and/or fountain.

### Processing liquid

The processing liquid may be an alkaline developer or solvent-based developer. Suitable alkaline developers have been described in US2005/0162505. An alkaline developer is an aqueous solution which has a pH of at least 11, more typically at least 12, preferably from 12 to 14. Alkaline developers typically contain alkaline agents to obtain high pH values can be inorganic or organic alkaline agents. The developers can comprise anionic, non-ionic and amphoteric surfactants (up to 3% on the total composition weight); biocides (antimicrobial and/or antifungal agents), antifoaming agents or chelating agents (such as alkali gluconates), and thickening agents (water soluble or water dispersible polyhydroxy compounds such as glycerine or polyethylene glycol).

Preferably, the processing liquid is a gum solution whereby during the development step the non-exposed areas of the photopolymerisable layer are removed from the support and the plate is gummed in a single step. The development with a gum solution has the additional benefit that, due to the remaining gum on the plate in the non-exposed areas, an additional gumming step is not required to protect the surface of the support in the non-printing areas. As a result, the precursor is processed and gummed in one single step which involves a less complex developing apparatus than a developing apparatus comprising a developer tank, a rinsing section and a gumming section. The gumming section may comprise at least one gumming unit or may comprise two or more gumming units. These gumming units may have the configuration of a cascade system, i.e. the gum solution, used in the second gumming unit and present in the second tank, overflows from the second tank to the first tank when gum replenishing solution is added in the second gumming unit or when the gum solution in the second gumming unit is used once-only, i.e. only starting gum solution is used to develop the precursor in this second gumming unit by preferably a spraying or jetting technique. More details concerning such gum development is described in EP1 788 444.

A gum solution is typically an aqueous liquid which comprises one or more surface protective compounds that are capable of protecting the lithographic image of a printing plate against contamination, e.g. by oxidation, fingerprints, fats, oils or dust, or damaging, e.g. by scratches during handling of the plate. Suitable examples of such surface protective compounds are film-forming hydrophilic polymers or surfactants. The layer that remains on the plate after treatment with the gum solution preferably comprises between 0.005 and 20 g/m² of the surface protective compound, more preferably between 0.010 and 10 g/m², most preferably between 0.020 and 5 g/m². More details concerning the surface protective compounds in the gum solution can be found in WO 2007/057348 page 9 line 3 to page 11 line 6. As the developed plate precursor is developed and gummed in one step, there is no need to post-treat the processed plate.

The gum solution preferably has a pH value between 3 and 11, more preferably between 4 and 10, even more preferably between 5 and 9, and most preferably between 6 and 8. A suitable gum solution is described in for example EP 1 342 568 in [0008] to [0022] and WO2005/111727. The gum solution may further comprise an inorganic salt, an anionic surfactant, a wetting agent, a chelate compound, an antiseptic compound, an antifoaming compound and/or an ink receptivity agent and/or combinations thereof. More details about these additional ingredients are described in WO 2007/057348 page 11 line 22 to page 14 line 19.

### Drying and baking step

After the processing step the plate may be dried in a drying unit. In a preferred embodiment the plate is dried by heating the plate in the drying unit which may contain at least one heating element selected from an IR-lamp, an UV-lamp, a heated metal roller or heated air.

After drying the plate can optionally be heated in a baking unit. More details concerning the heating in a baking unit can be found in WO 2007/057348 page 44 line 26 to page 45 line 20.

The lithographic printing plate precursor of the present invention can be prepared by (i) applying on a support as described above the coating as described above and (ii) drying the precursor. In a preferred embodiment, the support is a grained and anodized support which is not subjected to any post-anodic treatments as described above.

According to the present invention there is also provided a method for making a negative-working lithographic printing plate comprising the steps of imagewise exposing a printing plate precursor followed by developing the imagewise exposed precursor so that the non-exposed areas are dissolved in the developer solution. The development is preferably carried out by treating the precursor with a gum solution, however more preferably by mounting the precursor on a plate cylinder of a lithographic printing press and rotating the plate cylinder while feeding dampening liquid and/or ink to the precursor. Optionally, after the imaging step, a heating step is carried out to enhance or to speed-up the polymerization and/or crosslinking reaction. The lithographic printing plate precursor can be prepared by (i) applying on a support the coating as described above and (ii) drying the precursor. Any coating method can be used for applying one or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch.

The printing plate thus obtained can be used for conventional, so-called wet offset printing, in which ink and an aqueous dampening liquid is supplied to the plate. Another suitable printing method uses a so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

### EXAMPLES

### Example 1

### 1. Preparation of the printing plate precursors

### Preparation of the aluminium support S-01

A 0.3 mm thick aluminium foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/l SO42- ions and 5 g/l Al3+ ions at a temperature of 37°C and a current density of about 100 A/dm2. Afterwards, the aluminium foil was then desmutted by etching with an aqueous solution containing 5.5 g/l of NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm2, then washed with demineralised water for 11 seconds and dried at 120°C for 5 seconds.

The support thus obtained was characterized by a surface roughness Ra of 0.35-0.4 µm (measured with interferometer NT1100) and had an oxide weight of 3.0 g/m².

### Preparation of inventive printing plates PP-02 to PP-05 and comparative printing plate PP-01

### Photopolymerisable layer

The printing plate precursors were produced by coating onto the above described support S-01 the components as defined in Table 1 dissolved in a mixture of 35% by volume of MEK and 65% by volume of Dowanol PM (1-methoxy-2-propanol, commercially available from DOW CHEMICAL Company). The coating solution was applied at a wet coating thickness of 30 µm and then dried at 120°C for 1 minute in a circulation oven.

**Table 1: Composition of the photosensitive layer**

| **Ingredients** g/m² | **PL-01** |
|---|---|
| FST 510 (1) | 0.250 |
| CN 104 (2) | 0.250 |
| Initiator-01 (3) | 0.045 |
| S2539 (4) | 0.020 |
| Ruco coat EC4811 (5) | 0.250 |
| Tegoglide 410 (6) | 0.0015 |
| Sipomer PAM 100 (7) | 0.130 |
| Albritect CP 30 (8) | 0.024 |

| | |
|---|---|
| 1) FST 510 is a reaction product from 1 mole of 2,2,4-trimethylhexamethylenediisocyanate and 2 moles of hydroxyethyl-methacrylate commercially available from AZ Electronics as a 82 wt % solution in MEK; 2) CN 104 is an epoxy acrylate oligomer commercially available from Arkema; 3) Initiator-01 is bis(4-tert-butylphenyl)-iodonium tetraphenyl borate 4) S2539 is an infrared absorbing dye commercially available from FEW Chemicals 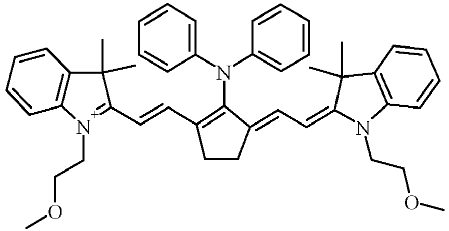 5) Ruco coat EC4811 is a polyether polyurethane commercially available from Rudolf Chemistry 6) Tegoglide 410 is a surfactant commercially available from Evonik Tego Chemie GmbH; 7) Sipomer PAM 100 is a methacrylate phosphonic ester commercially available from Rhodia; 8) Albritect CP 30, is a copolymer of vinylphosphonic acid and acrylic acid commercially available as a 20wt.% aqueous dispersion from Rhodia. | |

### Protective overcoat layer

On top of the photosensitive layer, a dispersion in water with the compositions as defined in Table 2 were coated (40 µm), and dried at 110°C for 2 minutes. Printing plate precursors PP-01 to PP-05 were obtained (Table 3).

**Table 2: Composition of the protective overcoat layers OC-01 to OC-05**

| Ingredients mg/m² | OC-01 Comp | OC-02 Inv | OC-03 Inv | OC-04 Inv | OC-05 Inv |
|---|---|---|---|---|---|
| Mowiol 4 - 88 (1) | 160 | 160 | 160 | 160 | 160 |
| Lutensol A8 (2) | 14 | 14 | 14 | 14 | 14 |
| IR dye (3) | 29 | 29 | 29 | 29 | 29 |
| KNO₃ | 37.5 | 37.5 | 37.5- | 37.5 | 37.5 |
| Na₃C₆H₅O₇ | - | 5 | 10 | 15 | 20 |
| PVDC (1) | 290 | 290 | 290 | 290 | 290 |

| | | | | | |
|---|---|---|---|---|---|
| 1) Mowiol 4-88 is a partially hydrolyzed polyvinylalcohol commercially available from Kuraray; 2) Lutensol A8TM is a surface active agent commercially available from BASF; 3) IR-01 is a thermochromic infrared absorbing dye having the following formula: 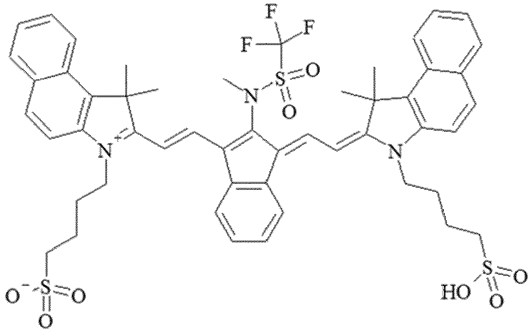 4) PVDC-1 is Diofan A050, PVDC-2 is Diofan A602, both polyvinylidene chloride latex commercially available from Solvay. | | | | | |

### 2. Humidity treatment

To evaluate the toning behaviour of the printing plate precursors upon exposure to high relative humidity, the printing plate precursors were subjected to a high relative humidity in a climate chamber. The climate chamber parameters were set at a relative humidity of 75% and a temperature of 26°C and the printing plate precursors were stored for a period of 5 days. Each of the printing plate precursors were placed so that the coating surface was maximally exposed to the environment. After the five day period, the printing plate precursors were removed from the climate chamber and imaged as described next.

### 3. Imaging

The obtained printing plate precursors with and without humidity treatment were subsequently imaged at 2400 dpi with a High Power Creo 40W TE38 thermal platesetter^{™} (200 lpi Agfa Balanced Screening (ABS)), commercially available from Kodak and equipped with a 830 nm IR laser diode, at energy density of 120 mJ/cm².

### 4. Processing and Printing

The imaged printing plates were mounted on a Heidelberg GTO 52 printing press. Each print job was started using K+E Skinnex 800 SPEED IK black ink (trademark of BASF Druckfarben GmbH) and 4 wt% Prima FS303 SF (trademark of Agfa Graphics) and 8% isopropanol in water as fountain solution. A compressible blanket was used and printing was performed on non-coated offset paper.

Prior to paper feeding, 10 press revolution with only the dampening system engaged followed by 5 revolutions with the inking rollers engaged was performed.

Up to 250 sheets were printed and visual assessment of sheet 250 was performed to evaluate the presence of toning (yes = "-" / no = "+") - i.e. accepting ink in the non-image areas.

### 5. Results

### Toning

The results of the visual assessment of toning in the image areas is given in Table 3.

**Table 3: Results of toning**

| **Printing plate** | **Overcoat layer** | **Humidity treatment*** | **Toning**** |
|---|---|---|---|
| PP-01 *comparative* | OC-01 | No | + |
| | | yes | - |
| PP-02 *inventive* | OC-02 | No | + |
| | | yes | + |
| PP-03 *inventive* | OC-03 | No | + |
| | | Yes | + |
| PP- 04 *inventive* | OC-04 | No | + |
| | | Yes | + |
| PP-05 *inventive* | OC-05 | No | + |
| | | Yes | + |

| | | | |
|---|---|---|---|
| * see above **Visual assessment of the image areas of sheet 250 (see above): -: toning in the image areas +: no toning in the image areas | | | |

The results in Table 3 show that the printing plates according to the present invention (PP-02 to PP-05) do not show toning in the image areas after exposure of the printing plates to the high humidity environment. The comparative printing plate PP-01 shows unacceptable toning in the image areas after the humidity treatment.

### Press life

The press life of each printing plate was evaluated by monitoring every 5.000 impressions the rendition (density) on the printed sheet of a test pattern with a nominal tone value of 40% (200 lpi ABS (Agfa Balanced Screening)) using a Gretag-MacBeth D19C (commercially available from GretagMacbeth AG, magenta filter setting). The press life of each printing plate is defined as the point where the density of the 40% test pattern starts to drop. The result of the press life test is a measure of the press life of the plate. Results are given in Table 4.

**Table 4: Presslife results**

| **Printing plate** | **Overcoat layer** | **Presslife** |
|---|---|---|
| PP-01 *comparative* | OC-01 | reference = 100% |
| PP-02 *inventive* | OC-02 | 100% |
| PP-03 *inventive* | OC-03 | 100% |
| PP- 04 *inventive* | OC-04 | 70% |
| PP-05 *inventive* | OC-05 | 50% |

Excellent press life results were obtained for the printing plates PP-01 to PP-03. The printing plates comprising a higher amount of citrate salt PP-04 and PP-05 exhibit a reduced presslife compared to the printing plates comprising a lower amount of citrate salt.

## Claims

1. A negative-working lithographic printing plate precursor including an aluminum support and a coating comprising a photopolymerisable layer and a toplayer provided above the photopolymerisable layer;
**characterized in that** the toplayer includes a non-polymeric polyfunctional compound including at least two carboxylic acid and/or carboxylate groups in an amount between 2 mg/m² and 80 mg/m².

2. The printing plate precursor according to claim 1 wherein the non-polymeric polyfunctional compound is present in the toplayer in an amount between 4 mg/m² and 50 mg/m².

3. The printing plate precursor according to claims 1 or 2 wherein the photopolymerisable layer further includes a hydrophobic binder.

4. The printing plate precursor according to claims 1 to 3 wherein the non-polymeric polyfunctional compound comprises at least three carboxyl and/or carboxylate groups.

5. The printing plate precursor according to claims 1 to 4 wherein the non-polymeric polyfunctional compound is an aliphatic organic acid and/or salt.

6. The printing plate precursor according to claim 5 wherein the aliphatic organic acid and/or salt is selected from citric acid, aconitic acid, isocitric acid and carballylic acid, and/or their salts.

7. The printing plate precursor according to any of the preceding claims
wherein a hydrophobic binder is present in the toplayer in an amount between 30%wt and 96%wt relative to the total weight of the toplayer.

8. The printing plate precursor according to claim 7 wherein the hydrophobic binder includes a monomeric unit derived from a vinyl monomer and/or a vinylidene monomer.

9. The printing plate precursor according to any of the preceding claims
wherein the photopolymerisable layer and/or the toplayer includes a colour precursor.

10. The printing plate precursor according to claim 9 wherein the colour precursor is an infrared-thermochromic dye which includes a thermocleavable group which transforms into a group which is a stronger electron-donor upon exposure to heat and/or IR radiation, and is capable of forming a print-out image upon exposure to heat and/or IR radiation.

11. The printing plate precursor according to claim 10 wherein the infrared-thermochromic dye is represented by Formula I: 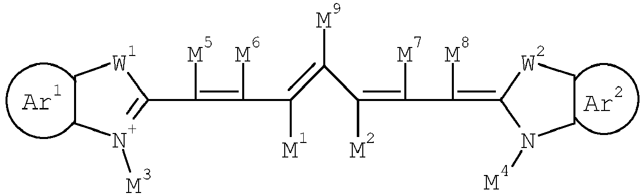 wherein
Ar¹ and Ar² independently represent an optionally substituted aromatic hydrocarbon group or an aromatic hydrocarbon group with an annulated benzene ring which is optionally substituted,
W¹ and W² independently represent a sulphur atom, an oxygen atom, NR" wherein R¨ represents an optionally substituted alkyl group, NH, or a - CM¹⁰M¹¹ group wherein M¹⁰ and M¹¹ are independently an optionally substituted aliphatic hydrocarbon group or an optionally substituted (hetero)aryl group, or wherein M¹⁰ and M¹¹ together comprise the necessary atoms to form a cyclic structure, preferably a 5- or 6-membered ring;
M¹ and M² independently represent hydrogen, an optionally substituted aliphatic hydrocarbon group or together comprise the necessary atoms to form an optionally substituted cyclic structure which may comprise an optionally substituted annulated benzene ring, preferably M¹ and M² together comprise the necessary atoms to form an optionally substituted cyclic structure which may comprise an optionally substituted annulated benzene ring, preferably a 5- or 6-membered ring, more preferably a 5-membered ring, most preferably a 5-membered ring having a cyclic structure of 5 carbon atoms;
M³ and M⁴ independently represent an optionally substituted aliphatic hydrocarbon group;
M⁵, M⁶, M⁷ and M⁸ independently represent hydrogen, a halogen or an optionally substituted aliphatic hydrocarbon group,
M⁹ is a group which is transformed by a chemical reaction, induced by exposure to IR radiation or heat, into a group which is a stronger electron-donor than said M⁹; and said transformation provides an increase of the integrated light absorption of said dye between 350 and 700nm;
and optionally one or more counter ions in order to obtain an electrically neutral compound.

12. A method for making a negative-working printing plate precursor including the step of
- coating on a support (i) a photopolymerisable layer including a polymerisable compound and a photoinitiator, and (ii) a toplayer as defined in any of the preceding claims provided above the photopolymerisable layer,
- drying the precursor.

13. A method for making a negative-working printing plate including the steps of
- image-wise exposing the printing plate precursor as defined in any of the preceding claims to heat and/or light radiation whereby a lithographic image consisting of image areas and non-image areas is formed,
- developing the exposed precursor.

14. The method according to claim 13 wherein the energy density of the light radiation is comprised between 75 mJ/cm² and 150 mJ/cm².

15. The method according to claims 13 or 14 wherein the precursor is developed by mounting the precursor on a plate cylinder of a lithographic printing press and rotating the plate cylinder while feeding dampening liquid and/or ink to the precursor.

## Patentansprüche

1. Ein negativ arbeitender lithografischer Druckplattenvorläufer, umfassend einen Aluminiumträger und eine Beschichtung, die eine fotopolymerisierbare Schicht und eine auf die fotopolymerisierbare Schicht aufgetragene Deckschicht umfasst, **dadurch gekennzeichnet, dass** die Deckschicht eine nicht-polymere polyfunktionelle Verbindung, die mindestens zwei Carbonsäuregruppen und/oder Carboxylatgruppen enthält, in einer Menge zwischen 2 mg/m² und 80 mg/m² enthält.

2. Der Druckplattenvorläufer nach Anspruch 1, wobei die nicht-polymere polyfunktionelle Verbindung in einer Menge zwischen 4 mg/m² und 50 mg/m² in der Deckschicht enthalten ist.

3. Der Druckplattenvorläufer nach den Ansprüchen 1 oder 2, wobei die fotopolymerisierbare Schicht ferner ein hydrophobes Bindemittel enthält.

4. Der Druckplattenvorläufer nach den Ansprüchen 1 bis 3, wobei die nicht-polymere polyfunktionelle Verbindung mindestens drei Carboxyl- und/oder Carboxylatgruppen umfasst.

5. Der Druckplattenvorläufer nach den Ansprüchen 1 bis 4, wobei die nicht-polymere polyfunktionelle Verbindung eine aliphatische organische Säure und/oder deren Salz ist.

6. Der Druckplattenvorläufer nach Anspruch 5, wobei die aliphatische organische Säure und/oder deren Salz aus Zitronensäure, Aconitäure, Isozitronensäure und Carballylsäure und/oder deren Salzen gewählt wird.

7. Der Druckplattenvorläufer nach einem der vorstehenden Ansprüche, wobei ein hydrophobes Bindemittel in einer Menge zwischen 30 Gew.-% und 96 Gew.-%, bezogen auf das Gesamtgewicht der Deckschicht, in der Deckschicht enthalten ist.

8. Der Druckplattenvorläufer nach einem der vorstehenden Ansprüche, wobei das hydrophobe Bindemittel eine von einem Vinylmonomer und/oder einem Vinylidenmonomer abgeleitete Monomereinheit umfasst.

9. Der Druckplattenvorläufer nach einem der vorstehenden Ansprüche, wobei die fotopolymerisierbare Schicht und/oder die Deckschicht einen Farbvorläufer enthält (enthalten).

10. Der Druckplattenvorläufer nach Anspruch 9, wobei der Farbvorläufer ein Infrarotlicht absorbierender, thermochromer Farbstoff ist, der eine thermisch spaltbare Gruppe enthält, die sich bei Erwärmung und/oder IR-Bestrahlung in eine Gruppe, die ein stärkerer Elektronendonator ist, umwandelt und in der Lage ist, bei Erwärmung und/oder IR-Bestrahlung ein Ausdruckbild zu bilden.

11. Der Druckplattenvorläufer nach Anspruch 10, wobei der Infrarotlicht absorbierende, thermochrome Farbstoff Formel I entspricht: 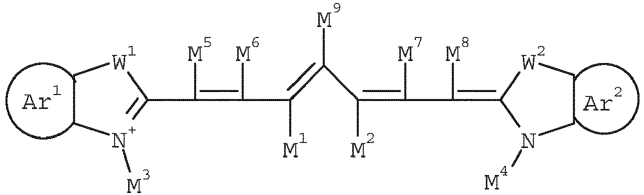 in der
Ar¹ und Ar² unabhängig voneinander eine gegebenenfalls substituierte aromatische Kohlenwasserstoffgruppe oder eine aromatische Kohlenwasserstoffgruppe mit einem gegebenenfalls substituierten anellierten Benzolring bedeuten,
W¹ und W² unabhängig voneinander ein Schwefelatom, ein Sauerstoffatom, NR", wobei R" eine gegebenenfalls substituierte Alkylgruppe bedeutet, NH, oder eine -CM¹⁰M¹¹-Gruppe bedeuten, wobei M¹⁰ und M¹¹ unabhängig voneinander eine gegebenenfalls substituierte aliphatische Kohlenwasserstoffgruppe oder eine gegebenenfalls substituierte (Hetero)arylgruppe bedeuten oder wobei M¹⁰ und M¹¹ gemeinsam die zur Bildung einer cyclischen Struktur, bevorzugt eines 5- oder 6-gliedrigen Ringes, benötigten Atome umfassen,
M¹ und M² unabhängig voneinander Wasserstoff oder eine gegebenenfalls substituierte aliphatische Kohlenwasserstoffgruppe bedeuten oder gemeinsam die zur Bildung einer gegebenenfalls substituierten cyclischen, gegebenenfalls einen gegebenenfalls substituierten anellierten Benzolring umfassenden Struktur benötigten Atome umfassen, wobei bevorzugt M¹ und M² gemeinsam die Atome umfassen, die benötigt sind zur Bildung einer gegebenenfalls substituierten cyclischen Struktur, die einen gegebenenfalls substituierten anellierten Benzolring, bevorzugt einen 5- oder 6-gliedrigen Ring, besonders bevorzugt einen 5-gliedrigen Ring, ganz besonders bevorzugt einen 5-gliedrigen Ring mit einer cyclischen Struktur von 5 Kohlenstoffatomen, umfassen kann,
M³ und M⁴ unabhängig voneinander eine gegebenenfalls substituierte aliphatische Kohlenwasserstoffgruppe bedeuten, M⁵, M⁶, M⁷ und M⁸ unabhängig voneinander Wasserstoff, Halogen oder eine gegebenenfalls substituierte aliphatische Kohlenwasserstoffgruppe bedeuten,
M⁹ eine Gruppe ist, die durch eine chemische, durch IR-Bestrahlung oder Erwärmung ausgelöste Reaktion in eine Gruppe, die ein stärkerer Elektronendonator als M⁹ ist, umgewandelt wird und die Umwandlung eine Zunahme der integrierten Lichtabsorption des Farbstoffes zwischen 350 nm und 700 nm mit sich bringt,
und gegebenenfalls ein oder mehrere Gegenionen, um eine elektrisch neutrale Verbindung zu erhalten, enthält.

12. Ein Verfahren zur Herstellung eines negativ arbeitenden Druckplattenvorläufers, umfassend die folgenden Schritte:
- Beschichten eines Trägers (i) mit einer fotopolymerisierbaren, eine polymerisierbare Verbindung und einen Fotoinitiator enthaltenden Schicht und (ii) einer wie nach einem der vorstehenden Ansprüche definierten, auf die fotopolymerisierbare Schicht aufgetragenen Deckschicht,
- Trocknen des Vorläufers.

13. Ein Verfahren zur Herstellung einer negativ arbeitenden Druckplatte, umfassend die folgenden Schritte:
- bildweises Erwärmen und/oder Bestrahlen mit Licht des wie nach einem der vorstehenden Ansprüche definierten Druckplattenvorläufers, wobei ein aus Bildbereichen und Nicht-Bildbereichen bestehendes lithografisches Bild gebildet wird,
- Entwicklung des erwärmten und/oder mit Licht bestrahlten Vorläufers.

14. Das Verfahren nach Anspruch 13, wobei die Energiedichte der Lichtstrahlung zwischen 75 mJ/cm² und 150 mJ/cm² liegt.

15. Das Verfahren nach den Ansprüchen 13 oder 14, wobei zur Entwicklung des Vorläufers der Vorläufer auf einen Plattenzylinder einer lithografischen Druckmaschine aufgespannt wird und bei sich drehendem Plattenzylinder Feuchtwasser und/oder Tinte auf den Vorläufer angebracht wird (werden).

## Revendications

1. Précurseur de plaque d'impression lithographique à effet négatif comprenant un support aluminium et un revêtement comprenant une couche photopolymérisable et une couche supérieure appliquée sur la couche photopolymérisable,
**caractérisé en ce que** la couche supérieure contient un composé polyfonctionnel non polymère comprenant au moins deux groupes acide carboxylique et/ou groupes carboxylate dans une quantité comprise entre 2 mg/m² et 80 mg/m².

2. Précurseur de plaque d'impression selon la revendication 1, **caractérisé en ce que** le composé polyfonctionnel non polymère est contenu dans la couche supérieure dans une quantité comprise entre 4 mg/m² et 50 mg/m².

3. Précurseur de plaque d'impression selon les revendications 1 ou 2, **caractérisé en ce que** la couche photopolymérisable contient en outre un liant hydrophobe.

4. Précurseur de plaque d'impression selon les revendications 1 à 3, **caractérisé en ce que** le composé polyfonctionnel non polymère comprend au moins trois groupes carboxyle et/ou groupes carboxylate.

5. Précurseur de plaque d'impression selon les revendications 1 à 4, **caractérisé en ce que** le composé polyfonctionnel non polymère est un acide organique aliphatique et/ou un sel de celui-ci.

6. Précurseur de plaque d'impression selon la revendication 5, **caractérisé en ce que** l'acide organique aliphatique et/ou le sel de celui-ci est choisi parmi l'acide citrique, l'acide aconitique, l'acide isocitrique et l'acide carballylique et/ou les sels de ceux-ci.

7. Précurseur de plaque d'impression selon l'une quelconque des revendications précédentes, **caractérisé en ce que** la couche supérieure contient un liant hydrophobe dans une quantité comprise entre 30% en poids et 96% en poids par rapport au poids total de la couche supérieure.

8. Précurseur de plaque d'impression selon l'une quelconque des revendications précédentes, **caractérisé en ce que** le liant hydrophobe comprend une unité monomère dérivée d'un monomère vinylique et/ou d'un monomère de vinylidène.

9. Précurseur de plaque d'impression selon l'une quelconque des revendications précédentes, **caractérisé en ce que** la couche photopolymérisable et/ou la couche supérieure contien(nen)t un précurseur de couleur.

10. Précurseur de plaque d'impression selon la revendication 9, **caractérisé en ce que** le précurseur de couleur est un colorant thermochromique absorbant la lumière infrarouge qui contient un groupe thermiquement clivable qui, lorsqu'il est exposé à de la chaleur et/ou et à du rayonnement infrarouge, se transforme en un groupe qui est un donneur d'électrons plus puissant et qui est capable de former une image directement visible lorsqu'il est exposé à de la chaleur et/ou et à du rayonnement infrarouge.

11. Précurseur de plaque d'impression selon la revendication 10, **caractérisé en ce que** le colorant thermochromique absorbant la lumière infrarouge répond à la Formule I: 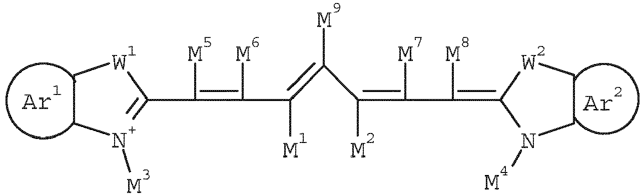 où
Ar¹ et Ar² représentent, l'un indépendamment de l'autre, un groupe hydrocarbure aromatique éventuellement substitué ou un groupe hydrocarbure aromatique comprenant un cycle benzénique éventuellement substitué,
W¹ et W² représentent, l'un indépendamment de l'autre, un atome de soufre, un atome d'oxygène, NR", où R" représente un groupe alkyle éventuellement substitué, NH, ou un groupe -CM¹⁰M¹¹, où M¹⁰ et M¹¹ représentent, l'un indépendamment de l'autre, un groupe hydrocarbure aliphatique éventuellement substitué ou un groupe (hétéro)aryle éventuellement substitué ou où M¹⁰ et M¹¹ comprennent ensemble les atomes nécessaires pour former une structure cyclique, de préférence un cycle à 5 ou 6 membres,
M¹ et M² représentent, l'un indépendamment de l'autre, de l'hydrogène ou un groupe hydrocarbure aliphatique éventuellement substitué ou comprennent ensemble les atomes nécessaires pour former une structure cyclique éventuellement substituée comprenant éventuellement un cycle benzénique annélé éventuellement substitué, M¹ et M² comprenant de préférence ensemble les atomes nécessaires pour former une structure cyclique éventuellement substituée pouvant comprendre un cycle benzénique annélé éventuellement substitué, de préférence un cycle à 5 ou 6 membres, un cycle à 5 membres étant particulièrement préféré et un cycle à 5 membres ayant une structure cyclique de 5 atomes de carbone étant le plus préféré, M³ et M⁴ représentent, l'un indépendamment de l'autre, un groupe hydrocarbure aliphatique éventuellement substitué, M⁵, M⁶, M⁷ et M⁸ représentent, l'un indépendamment de l'autre, de l'hydrogène, de l'halogène ou un groupe hydrocarbure aliphatique éventuellement substitué,
M⁹ est un groupe qui est transformé, par une réaction chimique induite par une exposition à du rayonnement infrarouge ou à de chaleur, en un groupe qui est un donneur d'électrons plus puissant que M⁹ et ladite transformation entraîne une augmentation de l'absorption de lumière intégrée dudit colorant entre 350 nm et 700 nm,
et contient éventuellement un ou plusieurs contre-ions afin d'obtenir un composé électriquement neutre.

12. Procédé pour la fabrication d'un précurseur de plaque d'impression à effet négatif comprenant les étapes consistant à:
- revêtir un support (i) d'une couche photopolymérisable contenant un composé polymérisable et un photoinitiateur et (ii) d'une couche supérieure telle que définie selon l'une quelconque des revendications précédentes et appliquée sur la couche photopolymérisable,
- sécher le précurseur.

13. Procédé pour la fabrication d'une plaque d'impression à effet négatif comprenant les étapes consistant à:
- exposer sous forme d'image à de la chaleur et/ou à du rayonnement de lumière le précurseur de plaque d'impression tel que défini selon l'une quelconque des revendications précédentes permettant ainsi de former une image lithographique composée de zones d'image et de zones exemptes d'image,
- développer le précurseur exposé.

14. Procédé selon la revendication 13, **caractérisé en ce que** la densité énergétique du rayonnement de lumière est comprise entre 75 mJ/cm² et 150 mJ/cm².

15. Procédé selon les revendications 13 ou 14, **caractérisé en ce que** le précurseur est développé en serrant le précurseur sur un cylindre porte-plaque d'une machine à imprimer lithographique et en faisant tourner le cylindre porte-plaque pendant qu'un liquide solution de mouillage et/ou de l'encre est (sont) appliquée(s) sur ledit précurseur.
